# EUROPEAN PATENT SPECIFICATION

(11) **EP 1 656 684 B1**
(45) Date of publication and mention of the grant of the patent: **18.05.2016**
(21) Application number: 04768129.1
(22) Date of filing: 19.08.2004
(51) Int. Cl.: H01G 9/20, H01L 51/42, C08F 26/00, C08F 226/00

(54) **PHOTOVOLTAIC CELL**
PHOTOVOLTAISCHE ZELLE
CELLULE PHOTOVOLTAIQUE

(30) Priority: 22.08.2003 GB 0319799
(43) Date of publication of application: 17.05.2006
(73) Proprietor: ITM Power (Research) Limited, Sheffield South Yorkshire S4 7QQ (GB)
(72) Inventor: HIGHGATE, Donald James, Dorking, Surrey RH5 6NS (GB); HARRISON, Lindsey, Sheffield S9 1XU (GB); BOURNE, Simon, Sheffield S9 1XU (GB)
(74) Representative: Gill Jennings & Every LLP
(86) International application number: PCT/GB2004/003570
(87) International publication number: WO 2005/020332

(56) References cited:
- US-A- 4 877 852
- US-A1- 2003 062 082
- US-A1- 2003 113 603
- US-B1- 6 555 840

## Description

### Field of the Invention

This invention relates to a photovoltaic cell.

### Background of the invention

A photovoltaic cell converts light energy into electrical energy, the "photovoltaic effect" being the process through which light energy is converted into electrical energy. Photovoltaic cells are typically solid state devices, usually semiconductors such as silicon. Usually one or more photosensitive electrodes are irradiated, simultaneously generating a voltage and a current.

Electrochemical cells may be in the form of a membrane electrode assembly (MEA), i.e. a cathode/membrane/anode assembly. MEAs typically have a multi-layered structure comprising (i) an Ion Exchange Membrane (IEM), (ii) a current-collecting electrode, and (iii) an electro-catalyst layer on each side.

WO-A-03/023890 describes a composite MEA formed by an *in situ* polymerisation process. This publication further describes an MEA having an improved reaction interface.

### Summary of the Invention

The present invention addresses the need for an efficient method of generating electrical energy *via* the photovoltaic effect. The invention involves the use of a MEA capable of transmitting light.

A first aspect of the invention is a photovoltaic cell which is a membrane electrode assembly capable of transmitting light. The membrane material is a polymer comprising a strongly ionic group. The assembly comprises a catalyst and preferably a dye sensitiser, and further comprises the features of claim 1.

A second aspect of the invention is a method for generating a voltage, which comprises irradiating a cell of the invention.

### Description of the Preferred Embodiments

The term "photovoltaic cell" as used herein refers to a cell which is capable of converting light energy into electrical energy.

The term "membrane electrode assembly" as used herein refers to a cathode/membrane/anode assembly.

The membrane may be capable of transmitting light. For example, the membrane may comprise one or channels for the transmission of light or may be optically transparent, preferably optically clear. The membrane material may be transparent to photons, e.g. high energy, visible or UV radiation. It is preferably malleable, so that it can formed into shapes which focus, concentrate and direct light as desired. Thus, for example, the MEA may be in the form of a light waveguide or lens.

The membrane material comprises a polymer which includes a strongly ionic group. The membrane may be formed by the polymerisation of monomers which include monomers such as hydroxyethyl methacrylate (HEMA), acrylonitrile (AN), methyl methacrylate (MMA), 2-acrylamido-2-methyl-1-propanesulphonic acid (AMPSA) and/or vinyl pyrrolidone (VP).

The material may be formed by the copolymerisation of monomers which include an electrically active comonomer. The electrically active component can be based either upon an acid, e.g. a sulphonic acid (SO₃), phosphoric or phosphonic acid, or an alkali (OH), e.g. KOH or NaOH or ammonium hydroxide. If electrically inactive comonomers are used, the material may be rendered electrically active by introducing strongly ionic molecules, for example using a swelling liquid technique.

Water can be used to cool the cell, maintain hydration and carry away excess energy as heat energy. Accordingly, the polymer is preferably hydrophilic, such that it is inherently able to absorb and transmit water throughout its molecular structure. Hydrophilic polymers can typically be formed by the copolymerisation from solution of a monomer mixture normally consisting of a hydrophobic/structural comonomer and a hydrophilic comonomer. The polymer is preferably cross-linked for greater stability. Cross-linked materials may be formed by applying ionising radiation to the material orby using a cross-linking agent. The use of additional cross-linking agents allows the final water uptake to be controlled separately from the electrical properties. The membrane may comprise integrated channels for the transmission of water.

The assembly comprises a suitable catalyst. Preferred catalysts include platinum and titanium dioxide. A dye sensitiser such as ruthenium (II) tris(2,2'-bipyridine)dichloride hexahydrate (ie. a compound of -Ru(bpy)₃²⁺), iodine or an iron complex with a suitable quenching compound (e.g. methyl violagen) may be used. Preferably, the sensitiser is disposed throughout the membrane. Any catalyst is preferably disposed on or near an electrode.

An electrode is, transparent (e.g. a tin oxide glass) to allow the transmission of photons through the electrode to reach the membrane. A carbon fabric maybe used as an electrode, and the fabric may be impregnated with a layer of catalyst. The assembly may be in the form of a stack of individual MEAs.

Further information regarding suitable materials and processes for the formation of MEAs may be found in WO-A-03/023890.

The following Examples illustrate the invention.

### Example 1

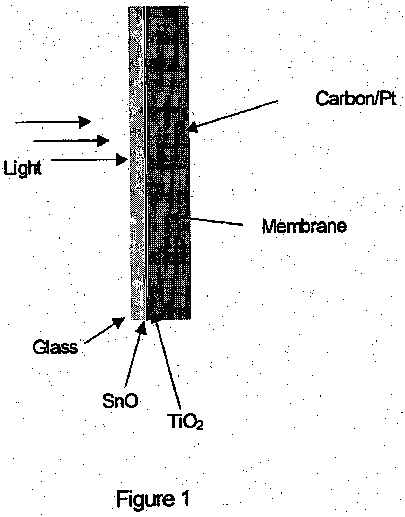

A cell of the invention was constructed using an AN-VP-AMPSA copolymer membrane. The electrode-catalyst systems used were tin oxide glass coated with titanium dioxide and carbon fabric coated with platinum. The cell is depicted in Figure 1.

A "blue" lamp (100 W electrical output) was used to illuminate the cell. The output of the cell was measured and was found to depend entirely on the presence of tight, giving an open circuit voltage of 0.59 V. The resulting current was dependent upon the light flux, reaching a maximum of 0.22 mA/cm².

### Example 2

A cell similar to that of Example 1 was produced, except that t/he membrane was formed by thermal polymerisation of the monomers *in situ* with the glass electrode plate.

The cell was irradiated as before, giving an open circuit voltage of 0.78 V.

## Claims

1. A photovoltaic cell which Is a membrane electrode assembly capable of transmitting light, wherein the membrane is a material comprising a hydrophilic polymer, the polymer comprising a strongly lonicgroup, and wherein the assembly comprises a catalyst **characterized in that** an electrode is transparent.

2. A cell according to claim 1, wherein the polymer is cross-linked.

3. A cell according to claim 1 or claim 2, wherein the membrane is a malleable material.

4. A cell according to any preceding claim, wherein the assembly is in the form of a stack.

5. A cell according to claim 1, wherein the catalyst. comprises platinum and/or titanium dioxide.

6. A cell according to any preceding claim, wherein the membrane comprises a channel suitable for the transmission of light.

7. A cell according to any preceding claim, wherein the membrane is optically transparent.

8. A cell according to any preceding claim, Wherein the assembly comprises a dye-sensitiser.

9. A cell according to any preceding claim, wherein the assembly is planar In structure.

10. A cell according to any preceding claim, wherein the ionic group is a sulphonic, phosphoric or phosphonic acid group or OH.

11. A method for generating a voltage, which comprises irradiating a cell according to any of claims 1 to 10.

## Patentansprüche

1. Photovoltaische Zelle, die eine Membran-Elektroden-Einheit ist, die fähig ist, Licht zu übertragen, wobei die Membran ein Materialist, das ein hydrophiles Polymer umfasst, wobei das Polymer eine stark ionische Gruppe umfasst und, wobei die Einheit einen Katalysator umfasst, **dadurch gekennzeichnet, dass** eine Elektrode transparent ist.

2. Zelle nach Anspruch 1, wobei das Polymer vernetzt ist.

3. Zelle nach Anspruch 1 oder Anspruch 2, wobei die Membran ein formbares Material ist.

4. Zelle nach irgendeinem vorhergehenden Anspruch, wobei die Einheit in Form eines Stapels ist.

5. Zelle nach Anspruch 1, wobei der Katalysator Platin- und/oder Titandioxid umfasst.

6. Zelle nach irgendeinem vorhergehenden Anspruch, wobei die Membran einen Kanal umfasst, der sich zur Übertragung von Licht eignet.

7. Zelle nach irgendeinem vorhergehenden Anspruch, wobei die Membran optisch transparent ist.

8. Zelle nach irgendeinem vorhergehenden Anspruch, wobei die Einheit ein Farbstoff-Sensibilisierungsmittel umfasst.

9. Zelle nach irgendeinem vorhergehenden Anspruch, wobei die Einheit strukturell ebenflächig ist.

10. Zelle nach irgendeinem vorhergehenden Anspruch, wobei die ionische Gruppe eine Sulfon-, Phosphor- oder Phosphonsäuregruppe oder OH ist.

11. Verfahren zum Erzeugen einer Spannung, welches das Bestrahlen einer Zelle nach irgendeinem der Ansprüche 1 bis 10 umfasst.

## Revendications

1. Cellule photovoltaïque qui est un assemblage membrane-électrodes capable de transmettre la lumière, dans laquelle la membrane est un matériau comprenant un polymère hydrophile, le polymère comprenant un groupement fortement ionique, et dans laquelle l'assemblage comprend un catalyseur, **caractérisée en ce qu'**une électrode est transparente.

2. Cellule selon la revendication 1, dans laquelle le polymère est réticulé.

3. Cellule selon la revendication 1 ou la revendication 2, dans laquelle la membrane est un matériau malléable.

4. Cellule selon l'une quelconque des revendications précédentes, dans laquelle l'assemblage est sous la forme d'un empilement.

5. Cellule selon la revendication 1, dans laquelle le catalyseur comporte le platine et/ou le dioxyde de titane.

6. Cellule selon l'une quelconque des revendications précédentes, dans laquelle la membrane comprend un canal approprié à la transmission de la lumière.

7. Cellule selon l'une quelconque des revendications précédentes, dans laquelle la membrane est optiquement transparente.

8. Cellule selon l'une quelconque des revendications précédentes, dans laquelle l'assemblage comprend un agent de sensibilisation par colorant.

9. Cellule selon l'une quelconque des revendications précédentes, dans laquelle l'assemblage est planaire en termes de structure.

10. Cellule selon l'une quelconque des revendications précédentes, dans laquelle le groupement ionique est un groupement acide sulfonique, phosphorique ou phosphonique ou un groupement OH.

11. Procédé de génération d'un voltage qui comprend l'irradiation d'une cellule selon l'une quelconque des revendications 1 à 10.
